# EUROPÄISCHE PATENTSCHRIFT

(11) **EP 2 286 416 B1**
(45) Veröffentlichungstag und Bekanntmachung des Hinweises auf die Patenterteilung: **13.09.2017**
(21) Anmeldenummer: 09741970.9
(22) Anmeldetag: 20.04.2009
(51) Int. Cl.: H01B 1/12, H01L 51/54, C08L 25/08, C08L 25/18, C08L 65/00

(54) **NEUARTIGE POLYTHIOPHENE-POLYANION-KOMPLEXE IN UNPOLAREN ORGANISCHEN LÖSUNGSMITTELN**
NOVEL POLYTHIOPHENE POLYANION COMPLEXES IN HOMOPOLAR ORGANIC SOLVENTS
NOUVEAUX TYPES DE COMPLEXES POLYTHIOPHÈNE-POLYANION DANS DES SOLVANTS ORGANIQUES NON POLAIRES

(30) Priorität: 09.05.2008 DE 102008023008
(43) Veröffentlichungstag der Anmeldung: 23.02.2011
(73) Patentinhaber: Heraeus Deutschland GmbH & Co. KG, 63450 Hanau (DE)
(72) Erfinder: LOEVENICH, Wilfried, 51469 Bergisch Gladbach (DE); KIRCHMEYER, Stephan, 51375 Leverkusen (DE); ELSCHNER, Andreas, 45479 Mühlheim (DE); REUTER, Knud, 47800 Krefeld (DE); MÜLLEN, Klaus, 50939 Köln (DE); KLAPPER, Markus, 55128 Mainz (DE); MÜLLER, Kevin, 65529 Waldems (DE)
(74) Vertreter: Herzog, Fiesser & Partner Patentanwälte PartG mbB
(86) Internationale Anmeldenummer: PCT/EP2009/054650
(87) Internationale Veröffentlichungsnummer: WO 2009/135752

(56) Entgegenhaltungen:
- EP-A- 1 564 251
- WO-A-02/080627
- OKAMURA H ET AL: "Synthesis of random and block copolymers of styrene and styrenesulfonic acid with low polydispersity using nitroxide-mediated living radical polymerization technique" POLYMER, ELSEVIER SCIENCE PUBLISHERS B.V, GB, Bd. 43, Nr. 11, 1. Mai 2002 (2002-05-01), Seiten 3155-3162, XP004346894 ISSN: 0032-3861 in der Anmeldung erwähnt
- LEE TAE-WOO ET AL: "Polymer light-emitting devices using ionomers as an electron injecting and hole blocking layer" JOURNAL OF APPLIED PHYSICS, AMERICAN INSTITUTE OF PHYSICS. NEW YORK, US, Bd. 90, Nr. 5, 1. September 2001 (2001-09-01), Seiten 2128-2134, XP012054028 ISSN: 0021-8979

## Beschreibung

Die Erfindung betrifft neuartige Polythiophen-Polyanion-Komplexe, die in unpolaren organischen Lösungsmitteln löslich oder dispergierbar sind, sowie deren Verwendung.

Leitfähige Polymere gewinnen zunehmend an wirtschaftlicher Bedeutung, da Polymere gegenüber Metallen Vorteile bezüglich der Verarbeitbarkeit, des Gewichts und der gezielten Einstellung von Eigenschaften durch chemische Modifikation haben. Beispiele für bekannte π-konjugierte Polymere sind Polypyrrole, Polythiophene, Polyaniline, Polyacetylene, Polyphenylene und Poly(p-phenylen-vinylene). Schichten aus leitfähigen Polymeren werden technisch vielfältig eingesetzt, z.B. als polymere Gegenelektrode in Kondensatoren oder zur Durchkontaktierung von elektronischen Leiterplatten. Die Herstellung leitfähiger Polymere erfolgt chemisch oder elektrochemisch oxidativ aus monomeren Vorstufen, wie z. B. gegebenenfalls substituierten Thiophenen, Pyrrolen und Anilinen und deren jeweiligen gegebenenfalls oligomeren Derivaten. Insbesondere die chemisch oxidative Polymerisation ist weit verbreitet, da sie technisch einfach in einem flüssigen Medium bzw. auf vielfältigen Substraten zu realisieren ist.

Ein besonders wichtiges und technisch genutztes Polythiophen ist das beispielsweise in der EP 339 340 A2 beschriebene Poly(ethylen-3,4-dioxythiophen) (PEDOT oder PEDT), das durch chemische Polymerisation von Ethylen-3,4-dioxythiophen (EDOT oder EDT) hergestellt wird und das in seiner oxidierten Form sehr hohe Leitfähigkeiten aufweist. Eine Übersicht über zahlreiche Poly(alkylen-3,4-dioxythiophen)-Derivate, insbesondere Poly(ethylen-3,4-dioxythiophen)-Derivate, deren Monomerbausteine, Synthesen und Anwendungen geben L. Groenendaal, F. Jonas, D. Freitag, H. Pielartzik & J. R. Reynolds, Adv. Mater. 12, (2000) S. 481 - 494.

Besondere technische Bedeutung haben Dispersionen von PEDOT mit Polystyrolsulfonsäure (PSS) erlangt, wie sie beispielsweise in der EP 0440 957 B1 offenbart sind. Aus diesen Dispersionen können transparente, leitfähige Filme erzeugt werden, die eine Vielzahl von Anwendungen gefunden haben, z.B. als antistatische Beschichtung oder als Lochinjektionsschicht in organischen Leuchtdioden.

Die Polymerisation von EDT erfolgt dabei in einer wässrigen Lösung von PSS, und es entsteht ein PEDT/PSS-Komplex. Kationische Polythiophene, die zur Ladungskompensation polymere Anionen als Gegenionen enthalten, werden in der Fachwelt auch oft als Polythiophen/Polyanion-Komplexe bezeichnet. Aufgrund der Polyelektrolyteigenschaften von PEDT als Polykation und PSS als Polyanion stellt dieser Komplex dabei keine echte Lösung dar, sondern eher eine Dispersion. Inwieweit Polymere oder Teile der Polymere dabei gelöst oder dispergiert sind, hängt vom Masscnvcrhältnis des Polykations und des Polyanions, von der Ladungsdichtc der Polymere, von der Salzkonzentration der Umgebung und von der Natur des umgebenden Mediums ab (V.Kabanov, Russian Chemical Reviews 74, 2005, 3 - 20). Die Übergänge können dabei fließend sein. Daher wird im Folgenden nicht zwischen den Begriffen "dispergiert" und "gelöst" unterschieden. Ebenso wenig wird zwischen "Dispergierung" und "Lösung" oder zwischen "Dispergierungsmittel" und "Lösungsmittel" unterschieden. Vielmehr werden diese Begriffe im Folgenden als gleichbedeutend verwendet.

Im Stand der Technik ist bisher nur die Herstellung von Polythiophen-Polyanion-Komplexen in polaren Lösungsmitteln möglich. In EP 0440957 A2 wird eine Herstellung von Polythiophen-Polyanion-Komplexen beschrieben, welche nur in sehr polaren Lösungsmitteln durchführbar ist, da die beispielsweise beschriebenen Polyanionen Polystyrolsulfonsäure und Poly(meta)acrylsäure nur in polaren Lösungsmitteln wie Wasser oder niedrigen Alkoholen löslich sind. Konkret wird lediglich die Polymerisation von PEDT in Wasser beschrieben. Nachteilhaft bei diesem Verfahren ist, dass die Auswahl des Lösungsmittels auf polare Lösungsmittel eingeschränkt ist, d.h. unpolare Lösungsmittel können bei diesem Herstellungsverfahren für Polythiophen-Polyanion-Komplexen nicht eingesetzt werden.

In EP 1373356 B1 und WO 2003/048228 wird die Herstellung von Polythiophcn-Polyanion-Komplexen in wasserfreien oder wasserarmen Lösungsmitteln beschrieben. Hierbei wird das Lösungsmittel Wasser gegen ein anderes mit Wasser mischbares organisches Lösungsmittel ausgetauscht. Dazu wird das zweite Lösungsmittel zugesetzt und anschließend Wasser, beispielsweise durch Destillation, entfernt. Diese Vorgehensweise hat den Nachteil, dass aufgrund der Destillation ein zweistufiges Verfahren eingesetzt werden muss. Außerdem muss das zugesetzte Lösungsmittel mit Wasser mischbar sein, was ebenfalls eine Einschränkung auf polare Lösungsmittel darstellt.

Otani et al. beschreiben in JP 2005-068166 ein Verfahren, bei dem ein leitfähiges Polymer wie PEDOT zunächst getrocknet und anschließend in einem organischen Lösungsmittel dispergiert wird. Als organische Lösungsmittel werden insbesondere solche genannt, die eine Dielektrizitätskonstante von 5 oder mehr haben. In den Beispielen werden Isoproplyalkohol und Gamma-butyrolacton genannt. Auch dieses Verfahren weist den Nachteil auf, dass zum erneuten Auflösen polare Lösungsmittel erforderlich sind. Außerdem ist bei diesem Verfahren nachteilhaft, dass das leitfähige Polymer zunächst synthetisiert, dann getrocknet und anschließend wieder dispergiert werden muss. Otani et al. offenbaren keine Polythiophen-Polyanion-Komplexe.

In 2002 beschreiben H. Okamura et al. (Polymer 2002, 43, 3155-3162) die Synthese eines Blockcopolymers von Styrol und Styrolsulfonsäure. Die Anteile der beiden Comonomere wurden variiert und es wurde herausgefunden, dass das Copolymer in Tetrahydrofuran, Chloroform, Aceton, Dimethylformamid, Methanol und Wasser löslich ist. Es wurde jedoch keinerlei Löslichkeit des besagten Copolymers in aliphatischen oder aromatischen Kohlenwasserstoffen wie Hexan, Toluol oder Benzol gefunden. Es wurden auch keinerlei Komplexe mit leitfähigen Polymeren, wie beispielsweise Polythiophen/Polyanion-Komplexe, hergestellt oder Leitfähigkeiten oder Widerstände von Filmen untersucht. Somit sind auch die von Okamura et al. beschriebenen Polymere nicht dazu geeignet, die Löslichkeit eines Polymerkomplexes in sehr unpolaren Lösungsmitteln wie Toluol zu gewährleisten.

In einer Reihe von Arbeiten wird außerdem beschrieben, wie die Löslichkeit eines Polythiophens durch das Anbringen von Seitengruppen am Thiophenmonomer und anschließende Polymerisation oder auch an durch Herstellen eines Blockcopolymers aus Thiopheneinheiten und Einheiten zur Löslichkeitssteigerung erreicht wird.

So beschreiben Luebben et al. in Polymeric Materials: Science & Engineering 2004, 91, 979 die Herstellung eines Blockcopolymers aus PEDOT und Polyethylenglycol. Als Gegenionen fungieren hier Perchlorat und p-Toluolsulfonsäure. Die Polymere sind in polaren organischen Lösungsmitteln wie Propylencarbonat und Nitromethan löslich. Es werden Leitfähigkeiten von 10 ⁻⁴ S/cm bis 1 S/cm gemessen. Die genannten Blockcopolymere haben jedoch den Nachteil, dass sie nur in sehr polaren Lösungsmitteln löslich sind. Außerdem tragen die gewählten Gcgcnioncn nicht zur Filmbildung bei, so dass mit diesen Blockcopolymeren keine leitfähigen Filme gebildet werden können.

Weitere Veröffentlichungen beschreiben die Herstellung von organischen Polythiophenlösungen durch die Einführung von Seitengruppen am Thiophen, die zur Löslichkeit beitragen. So beschreiben Yamamoto et al. in Polymer 43, 2002, 711-719 die Herstellung des Hexylderivates von PEDOT, welches als neutrales Molekül in organischen Lösungsmitteln löslich ist. Auch die Dotierung bzw. Oxidation mit Iod wird beschrieben. Es gibt jedoch keinen Hinweis darauf, ob sich aus organischen Lösungen des dotierten bzw. oxidierten Thiophens leitfähige Filme herstellen lassen. Weiterhin nachteilhaft bei dieser Herangehensweise ist, dass das Molekulargewicht der Polymere niedrig ist und daher die Filmformungseigenschaften schlecht sind. In der oben genannten Veröffentlichung werden Molekulargewichte (M_{w}) von 2400 g/mol und 8500 g/mol erreicht. Da das Polythiophen gleichzeitig als filmformendes Polymer und als leitfähiges Polymer fungiert, können die beiden Eigenschaften nicht unabhängig voneinander eingestellt werden. Grundsätzlich birgt diese Methode den Nachteil, dass durch die Einführung von Seitenketten am Thiophen nicht nur die Löslichkeitseigenschaften, sondern auch die elektronischen Eigenschaften des Moleküls beeinflusst werden.

WO 02/080627 A offenbart eine Elektroluminszenz-Anordnung umfassend ein transluzentes Substrat, eine transparente oder transluzente erste Elektrode, eine zweite leitfähige Elektrode und eine elektrolumineszierende Phosphorschicht zwischen der transparenten oder transluzenten ersten Elektrode und der zweiten leitfähigen Elektrode, wobei die erste und die zweite Elektrode jeweils ein Polymer oder Copolymer von 3,4-Dialkoxythiophen umfassen, welches jeweils gleich oder verschieden sein kann und in dem die beiden Alkoxy-Gruppen gleich oder verschieden sein oder zusammen eine gegebenenfalls substituierte Oxo-Alkylen-Oxo-Brücke können bilden.

EP 1 564 251 A offenbart eine Formulierung enthaltend wenigstens ein Polythiophen, wenigstens ein SO₃⁻M⁺- oder COO⁻M⁺-Gruppen enthaltendes Polymer, wobei M⁺ für H⁺, Li⁺, Na⁺, K⁺, Rb⁺, Cs⁺ oder NH₄⁺ steht, und wenigstens ein SO₃⁻M⁺- oder COO⁻M⁺-Gruppen enthaltendes, teilfluoriertes oder perfluoriertes Polymer, wobei M⁺ für H⁺, Li⁺, Na⁺, K⁺, Rb⁺, Cs⁺ oder NH₄⁺ steht.

Tae-Woo Lee at al. (Journal of Applied Physics 2001, 90 (5), 2128-2134) beschreiben den Einfluss der Ionenkonzentration, des Neutralisationsgrades und der Gegenionen in sulfonisierten Polystyrol-Ionomeren, die als Elektronen-Injektionsschicht in einer Elektroluminszenz-Anordnung eingesetzt werden. Es bestand somit ein Bedarf an Dispersionen von elektrisch leitfähigen Polythiophenen in unpolaren Lösungsmitteln, mit denen leitfähige Filme hergestellt werden können. Dieser Bedarf beruht auf der Tatsache, dass solche Dispersionen bisher nur in sehr polaren Lösungsmitteln verfügbar sind. Insbesondere besteht ein Bedarf an Dispersionen in unpolaren Lösungsmitteln, die gute Filmformungseigenschaften und eine elektrische Leitfähigkeit zeigen. Da viele Lacksysteme auf unpolaren Lösungsmitteln basieren, besteht ein großer Bedarf an leitfähigen Polythiophenen, welche in unpolaren Lösungsmitteln gelöst oder dispergiert sind.

Die Aufgabe bestand somit darin, Dispersionen von Polythiophenen herzustellen, die in unpolaren Lösungsmitteln löslich sind und aus denen leitfähige Filme hergestellt werden können. Weiterhin bestand die Aufgabe darin solche Dispersionen herzustellen, wobei das bei der Synthese verwendete Lösungsmittel gleichzeitig das Lösungsmittel der fertigen Dispersion ist, so dass kein Austausch des Lösungsmittels erforderlich ist.

Überraschend wurde nun gefunden, dass Komplexe aus gegebenenfalls substituierten Polythiophenen und Polyanionen, wobei die Polyanionen Copolymere umfassen, diese Aufgabe lösen.

Gegenstand der vorliegenden Erfindung ist somit ein Komplex umfassend ein gegebenenfalls substituiertes Polythiophen und ein Polyanion, dadurch gekennzeichnet, dass das Polyanion ein Copolymer mit wiederkehrenden Einheiten der allgemeinen Formeln (I) und (III), oder wiederkehrenden Einheiten der allgemeinen Formeln (II) und (III), oder wiederkehrenden Einheiten der allgemeinen Formeln (I), (II) und (III) enthält 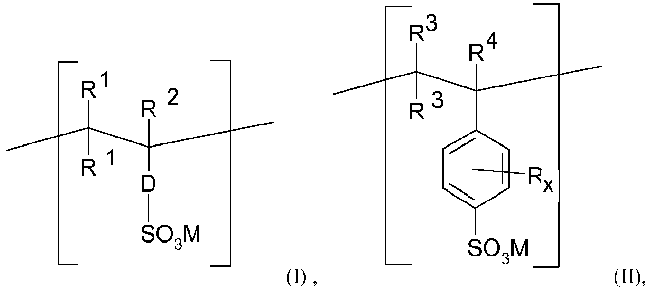 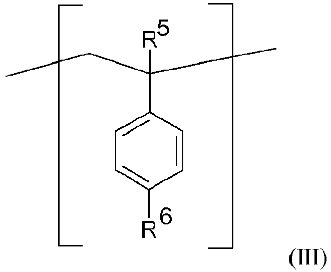 wobei
- R¹, R², R³,R⁴,R⁵: unabhängig voneinander jeweils für H, einen gegebenenfalls substituierten C₁-C₁₈-Alkylrest, einen gegebenenfalls substituierten C₁-C₁₈-Alkoxyrest, einen gegebenenfalls substituierten C₅-C₁₂-Cycloalkylrest, einen gegebenenfalls substituierten C₆-C₁₄-Arylrest, einen gegebenenfalls substituierten C₇-C₁₈-Aralkylrest, einen gegebenenfalls substituierten C₁-C₄-Hydroxyalkylrest oder einen Hydroxylrest, bevorzugt für H steht,
- R⁶: einen gegebenenfalls substituierten C₁-C₃₀-Alkylrest, bevorzugt für einen C₂ - C₁₈ - Alkylrest, darstellt,
- D: für eine direkte kovalente Bindung oder einen gegebenenfalls substituierten C₁-C₅-Alkylenrest steht
- R: für einen linearen oder verzweigten, gegebenenfalls substituierten C₁-C₁₈ Alkylrest, einen gegebenenfalls substituierten C₅-C₁₂-Cycloalkylrest, einen gegebenenfalls substituierten C₆-C₁₄-Arylrest, einen gegebenenfalls substituierten C₇-C₁₈-Aralkylrest, einen gegebenenfalls substituierten C₁-C₄-Hydroxyalkylrest oder einen Hydroxylrest, bevorzugt für H, steht,
- x: für eine ganze Zahl von 0 bis 4, bevorzugt für 0, 1 oder 2, besonders bevorzugt für 0 oder 1, steht, und
- M: für H oder Li⁺, Na⁺, K⁺, Rb⁺, Cs⁺, NH₄⁺, Na⁺, K⁺ oder ein anderes Kation, bevorzugt für H, steht.

Die allgemeine Formel (II) ist so zu verstehen, dass der Substituent R x-mal am aromatischen Ring gebunden sein kann.

In einer bevorzugten Ausführungsform der Erfindung stellt das Polyanion des Komplexes ein Copolymer mit wiederkehrenden Einheiten der Formeln (II) und (III) dar.

In einer noch weiteren bevorzugten Ausführungsform der Erfindung ist das Polyanion ein Copolymer mit wiederkehrenden Einheiten der Formeln (IIa) und (III) 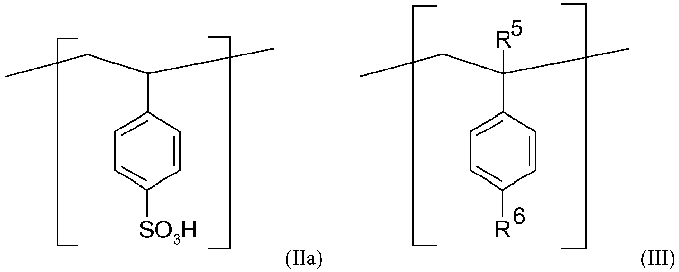 wobei
- R⁵: für H oder einen gegebenenfalls substituierten C₁-C₁₈-Alkylrest, bevorzugt für H oder einen gegebenenfalls substituierten C₁-C₆-Alkylrest, besonders bevorzugt für einen Methylrest oder H, ganz besonders bevorzugt für H steht, und
- R⁶: einen gegebenenfalls substituierten C₁-C₃₀-Alkylrest, bevorzugt für einen gegebenenfalls substiuicrtcn C₁-C₂₀-Alkylrest, besonders bevorzugt für einen gegebenenfalls substituierten C₁-C₁₂-Alkylrest, darstellt.

Der Anteil der wiederkehrenden Einheiten der allgemeinen Formeln (I), (II) und (III) im Gesamtpolymer beträgt a, b beziehungsweise c. Hierbei stehen a, b und c für Massenprozente, die zwischen 0 -100% liegen. Bevorzugt liegen a und b zwischen 0 und 50%, wobei a und b nicht gleichzeitig 0% betragen dürfen. Der Anteil c liegt bevorzugt zwischen 20 - 100%.

Im Rahmen der Erfindung steht C₁-C₁₈-Alkyl für lineare oder verzweigte C₁-C₁₈-Alkylreste wie beispielsweise Methyl, Ethyl, n- oder iso-Propyl, n-, iso-, sec- oder tert-Butyl, n-Pentyl, 1-Methylbutyl, 2-Methylbutyl, 3-Methylbutyl, 1-Ethylpropyl, 1,1-Dimethylpropyl, 1,2-Dimethylpropyl, 2,2-Dimethylpropyl, n-Hexyl, n-Heptyl, n-Octyl, 2-Ethylhexyl, n-Nonyl, n-Decyl, n-Undecyl, n-Dodecyl, n-Tridecyl, n-Tetradecyl, n-Hexadecyl, n-Heptadecyl oder n-Octadecyl; C₁-C₃₀-Alkyl steht für lineare oder verzweigte C₁-C₃₀-Alkylreste, welche neben den oben genannten C₁-C₁₈ Alkylresten Alkylreste wie beispielsweise n-Nonadecyl, n-Eicosanyl, n-Henicosanyl, n-Docosanyl, n-Tricosanyl, n-Tetracosanyl, n-Pentacosanyl, n-Hexacosanyl, n-Heptacosanyl, n-Octacosanyl, n-Nonycosanyl oder n-Triacontanyl. C₁-C₁₈-Alkoxyreste stehen im Rahmen der Erfindung für die den vorangehend aufgeführten C₁-C₁₈-Alkylresten entsprechenden Alkoxyreste. C₅-C₁₂-Cycloalkyl steht im Rahmen der Erfindung für C₅-C₁₂-Cycloalkylreste wie Cyclopentyl, Cyclohexyl, Cycloheptyl, Cyclooctyl, Cyclononyl oder Cyclodecyl, C₆-C₁₄-Aryl für C₆-C₁₄-Arylreste wie Phenyl oder Naphthyl, und C₇-C₁₈-Aralkyl für C₇-C₁₈-Aralkylreste wie beispielsweise Benzyl, o-, m-, p-Tolyl, 2,3-, 2,4-, 2,5-, 2,6-, 3,4-, 3,5-Xylyl oder Mesityl. Unter einem C₁-C₄-Hydroxyalkyl wird im Rahmen der Erfindung ein C₁-C₄-Alkylrest verstanden, welcher als Substituenten eine Hydroxygruppe aufweist, und wobei der C₁-C₄-Alkylrest beispielsweise Methyl, Ethyl, n- oder iso-Propyl, n-, iso-, sec- oder tert-Butyl darstellen kann; unter einem C₁-C₅-Alkylenreste wird ein Methylen, Ethylen, n-Propylen, n-Butylen oder n-Pentylen verstanden. Die vorangehende Aufzählung dient der beispielhaften Erläuterung der Erfindung und ist nicht als abschließend zu betrachten.

Im Rahmen der Erfindung weisen die Polyanionen ein Gewichtsmittel (M_{w}) des Molekulargewichtes auf, welches zwischen 2 000 bis 5 000 000 g/mol, bevorzugt zwischen 10 000 bis 1 000 000 g/mol, und ganz besonders bevorzugt zwischen 40 000 g/mol und 600 000 g/mol liegt.

Das Molekulargewicht der Polyanionen kann mittels Gelpermeationschromatographie (GPC) bestimmt werden. Dazu wird das Polymer in einem Lösungsmittel (z.B. Chloroform oder Tetrahydrofuran) gelöst und über eine GPC Säule gegeben. Als Referenzstandard kann Polystyrol im gleichen Lösungsmittel dienen. Als Detektor können UV-Detektor oder Brechungsindexdetektor dienen.

Die Polyanionen können aus den entsprechenden Monomeren hergestellt werden. Dabei wird das Verhältnis der Wiederholungseinheiten im Polymer über das Verhältnis der eingesetzten Monomere bestimmt, wobei die genannten Verhältnisse aufgrund unterschiedlicher Reaktionsgeschwindigkeiten nicht identisch sein müssen. Die Polymerisation kann mit radikalischen, anionischen oder kationischen Initiatoren gestartet werden. Außerdem können Übergangsmetallkomplexe zu Initiierung dienen. Synthesemethoden zur Herstellung von Polymeren sind im Handbuch "Makromoleküle" von H.-G. Elias, Band 1 beschrieben.

Neben den oben näher definierten Polyanionen umfasst der erfindungsgemäße Komplex gegebenenfalls substituierte Polythiophene enthaltend wiederkehrende Einheiten der allgemeinen Formel (IV), 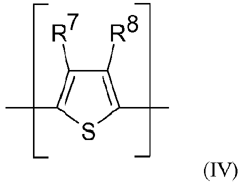 wobei
- R⁷ und R⁸: unabhängig voneinander jeweils für H, einen gegebenenfalls substituierten C₁-C₁₈-Alkylrest oder einen gegebenenfalls substituierten C₁-C₁₈-Alkoxyrest, oder
- R⁷ und R⁸: zusammen für einen gegebenenfalls substituierten C₁-C₈-Alkylenrest, einen gegebenenfalls substituierten C₁-C₈-Alkylenrest, worin ein oder mehrere C-Atom(e) durch ein oder mehrere gleiche oder unterschiedliche Heteroatome ausgewählt aus O oder S ersetzt sein können, bevorzugt einen C₁-C₈-Dioxyalkylenrest, einen gegebenenfalls substituierten C₁-C₈-Oxythiaalkylenrest oder einen gegebenenfalls substituierten C₁-C₈-Dithiaalkylenrest, oder für einen gegebenenfalls substituierten C₁-C₈-Alkylidenrest, worin gegebenenfalls wenigstens ein C-Atom durch ein Heteroatom ausgewählt aus O oder S ersetzt sein kann, stehen.

In bevorzugten Ausführungsformen sind Polythiophene enthaltend wiederkehrende Einheiten der allgemeinen Formel (IV) solche enthaltend wiederkehrende Einheiten der allgemeinen Formel (IVa) und/oder der allgemeinen Formel (IV-b) 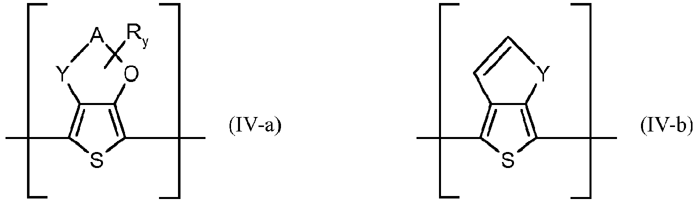 worin
- A: für einen gegebenenfalls substituierten C₁-C₅-Alkylenrest, bevorzugt für einen gegebenenfalls substituierten C₂-C₃-Alkylenrest steht,
- Y: für O oder S steht,
- R: für einen linearen oder verzweigten, gegebenenfalls substituierten C₁-C₁₈-Alkylrest, bevorzugt linearen oder verzweigten, gegebenenfalls substituierten C₁-C₁₄-Alkylrest, einen gegebenenfalls substituierten C₅-C₁₂-Cycloalkylrest, einen gegebenenfalls substituierten C₆-C₁₄-Arylrest, einen gegebenenfalls substituierten C₇-C₁₈-Aralkylrest, einen gegebenenfalls substituierten C₁-C₄-Hydroxyalkylrest oder einen Hydroxylrest steht,
- y: für eine ganze Zahl von 0 bis 8, bevorzugt für 0, 1 oder 2, besonders bevorzugt für 0 oder 1, steht, und
für den Fall, dass mehrere Reste R an A gebunden sind, diese gleich oder unterschiedlich sein können.

Die allgemeine Formeln (IV-a) ist so zu verstehen, dass der Substituent R y-mal an den Alkylenrest A gebunden sein kann.

In weiteren bevorzugten Ausführungsformen sind Polythiophene enthaltend wiederkehrende Einheiten der allgemeinen Formel (IV) solche enthaltend wiederkehrende Einheiten der allgemeinen Formel (IV-aa) und/oder der allgemeinen Formel (IV-ab) 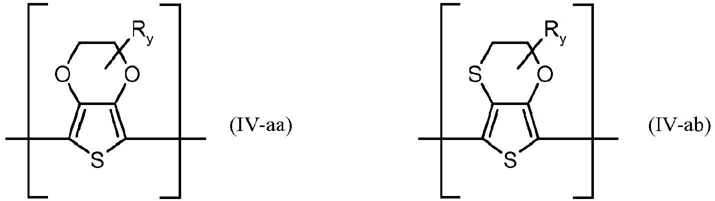 worin
R und y die oben genannte Bedeutung haben.

In noch weiteren bevorzugten Ausführungsformen Polythiophene enthaltend wiederkehrende Einheiten der allgemeinen Formel (IV) solche enthaltend Polythiophene der allgemeinen Formel (IV-aaa) und/oder der allgemeinen Formel (IV-aba)

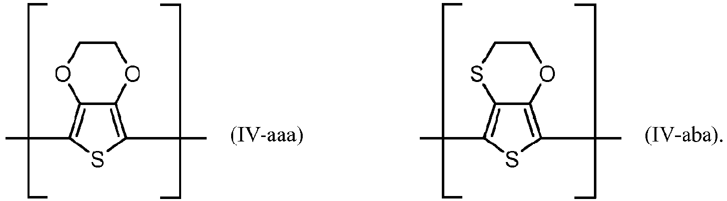

Unter dem Präfix Poly- ist im Rahmen der Erfindung zu verstehen, dass mehr als eine gleiche oder verschiedene wiederkehrende Einheit im Polythiophen enthalten ist. Die Polythiophene enthalten insgesamt n wiederkehrende Einheiten der allgemeinen Formel (IV), wobei n eine ganze Zahl von 2 bis 2000, bevorzugt 2 bis 100, sein kann. Die wiederkehrenden Einheiten der allgemeinen Formel (IV) können innerhalb eines Polythiophens jeweils gleich oder verschieden sein. Bevorzugt sind Polythiophene enthaltend jeweils gleiche wiederkehrende Einheiten der allgemeinen Formel (IV).

An den Endgruppen tragen die Polythiophene bevorzugt jeweils H.

In besonders bevorzugten Ausführungsformen ist das Polythiophen mit wiederkehrenden Einheiten der allgemeinen Formel (I) Poly(3,4-ethylendioxythiophen), Poly(3,4-ethylenoxythiathiophen) oder Poly(thieno[3,4-b]thiophen, d.h. ein Homopolythiophen aus wiederkehrenden Einheiten der Formel (IV-aaa), (IV-aba) oder (IV-b).

In weiteren besonders bevorzugten Ausführungsformen ist das Polythiophen mit wiederkehrenden Einheiten der allgemeinen Formel (IV) ein Copolymer aus wiederkehrenden Einheiten der Formel (IV-aaa) und (IV-aba), (IV-aaa) und (IV-b), (IV-aba) und (IV-b) oder (IV-aaa), (IV-aba) und (IVb), wobei Copolymere aus wiederkehrenden Einheiten der Formel (IV-aaa) und (IV-aba) sowie (IV-aaa) und (IV-b) bevorzugt sind.

C₁-C₅-Alkylenreste A sind im Rahmen der Erfindung Methylen, Ethylen, n-Propylen, n-Butylen oder n-Pentylen, C₁-C₈-Alkylenreste darüber hinaus n-Hexylen, n-Heptylen und n-Oktylen. C₁-C₈-Alkylidenreste sind im Rahmen der Erfindung vorangehend aufgeführte C₁-C₈-Alkylenreste enthaltend wenigstens eine Doppelbindung. C₁-C₈-Dioxyalkylenreste, C₁-C₈-Oxythiaalkylenreste und C₁-C₈-Dithiaalkylenreste stehen im Rahmen der Erfindung für die den vorangehend aufgeführten C₁-C₈-Alkylenreste entsprechenden C₁-C₈-Dioxyalkylenreste, C₁-C₈-Oxythiaalkylenreste und C₁-C₈-Dithiaalkylenreste. C₁-C₁₈-Alkyl, C₅-C₁₂-Cycloalkyl, C₆-C₁₄-Aryl, C₇-C₁₈-Aralkyl, C₁-C₁₈-Alkoxy und C₁-C₄-Hydroxyalkyl weisen die oben aufgeführte Bedeutung auf. Die vorangehende Aufzählung dient der beispielhaften Erläuterung der Erfindung und ist nicht als abschließend zu betrachten.

Als gegebenenfalls weitere Substituenten der vorangehenden Reste kommen zahlreiche organische Gruppen in Frage, beispielsweise Alkyl-, Cycloalkyl-, Aryl-, Halogen-, Ether-, Thioether-, Disulfid-, Sulfoxid-, Sulfon-, Sulfonat-, Amino-, Aldehyd-, Keto-, Carbonsäureester-, Carbonsäure-, Carbonat-, Carboxylat-, Cyano-, Alkylsilan- und Alkoxysilangruppen sowie Carboxylamidgruppen.

Verfahren zur Herstellung der monomeren Vorstufen für die Herstellung der Polythiophene der allgemeinen Formel (IV) sowie deren Derivaten sind dem Fachmann bekannt und beispielsweise in L. Groenendaal, F. Jonas, D. Freitag, H. Pielartzik & J. R. Reynolds, Adv. Mater. 12 (2000) 481 - 494 und darin zitierter Literatur beschrieben.

Unter Derivaten der vorangehend aufgeführten Thiophene werden im Sinne der Erfindung beispielsweise Dimere oder Trimere dieser Thiophene verstanden. Es sind auch höhermolekulare Derivate, d.h. Tetramere, Pentamere etc. der monomeren Vorstufen als Derivate möglich. Die Derivate können sowohl aus gleichen wie unterschiedlichen Monomereinheiten aufgebaut sein und in reiner Form sowie im Gemisch untereinander und/oder mit den vorangehend genannten Thiophenen eingesetzt werden. Auch oxidierte oder reduzierte Formen dieser Thiophene und Thiophenderivate sind im Sinne der Erfindung von dem Begriff Thiophene und Thiophenderivate umfasst, sofern bei ihrer Polymerisation die gleichen leitfähigen Polymeren entstehen wie bei den vorangehend aufgeführten Thiophenen und Thiophenderivaten.

Die Dispersion oder Lösung kann zusätzlich wenigstens ein polymeres Bindemittel enthalten. Geeignete Bindemittel sind polymere, organische Binder, beispielsweise Polyvinylalkohole, Polyvinylpyrrolidone, Polyvinylchloride, Polyvinylacetate, Polyvinylbutyrate, Polyacrylsäureester, Polyacrylsäureamide, Polymethacrylsäureester, Polymethacryl-säureamide, Polyacrylnitrile, Styrol/Acrylsäureester-, Vinylacetat/Acrylsäureester- und Ethylen/Vinylacetat-Copolymerisate, Polybutadiene, Polyisoprene, Polystyrole, Polyether, Polyester, Polycarbonate, Polyurethane, Polyamide, Polyimide, Polysulfone, Melamin-Formaldehyharze, Epoxidharze, Siliconharze oder Cellulosen.

Die gegebenenfalls substituierten Polythiophene sind kationisch, wobei sich "kationisch" nur auf die Ladungen bezieht, die auf der Polythiophenhauptkette sitzen. Je nach Substituent an den Resten R können die Polythiophene positive und negative Ladungen in der Struktureinheit tragen, wobei sich die positiven Ladungen auf der Polythiophenhauptkette und die negativen Ladungen gegebenenfalls an den durch Sulfonat- oder Carboxylatgruppen substituierten Resten R befinden. Dabei können die positiven Ladungen der Polythiophenhauptkette zum Teil oder vollständig durch die gegebenenfalls vorhandenen anionischen Gruppen an den Resten R abgesättigt werden. Insgesamt betrachtet können die Polythiophene in diesen Fällen kationisch, neutral oder sogar anionisch sein. Dennoch werden sie im Rahmen der Erfindung alle als kationische Polythiophene betrachtet, da die positiven Ladungen auf der Polythiophenhauptkette maßgeblich sind. Die positiven Ladungen sind in den Formeln nicht dargestellt, da ihre genaue Zahl und Position nicht einwandfrei feststellbar sind. Die Anzahl der positiven Ladungen beträgt jedoch mindestens 1 und höchstens n, wobei n die Gesamtanzahl aller wiederkehrenden Einheiten (gleicher oder unterschiedlicher) innerhalb des Polythiophens ist.

Der erfindungsgemäße Polythiophen/Polyanion-Komplex ist in einem Lösungsmittel löslich oder dispcrgicrbar, welches nicht mit Wasser mischbar ist. Als geeignete Lösungsmittel seien vor allem folgende unter den Reaktionsbedingungen inerte organische Lösungsmittel genannt: Aromatische Kohlenwasserstoffe wie Toluol und Xylol; aliphatische Kohlenwasserstoffe wie Hexan, Heptan und Cyclohexan; aliphatische Carbonsäureester wie Ethylacetat; Chlorkohlenwasserstoffe wie Dichlormethan und Dichlorethan; aliphatische und araliphatische Ether wie Diethylether oder Tetrahydrofuran. Besonders bevorzugt sind aliphatische und aromatische Kohlenwasserstoffe.

Die gegebenenfalls substituierten Polythiophene gemäß der allgemeinen Formel (IV) können durch oxidative Polymerisation von gegebenenfalls substituierten Thiophenen der allgemeinen Formel (V) hergestellt werden. 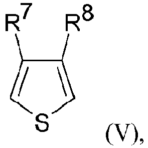 wobei R⁷ und R⁸ die oben genannte Bedeutung haben. Für die gegebenenfalls substituierten Thiophene der allgemeinen Formel (V) gelten die gleichen Vorzugsbereiche wie für die gegebenenfalls substituierten Polythiophene der allgemeinen Formel (IV).

Für diese oxidative Polymerisation können die dem Fachmann bekannten für die oxidative Polymerisation von Thiophenen geeigneten Oxidationsmittel verwendet werden; diese sind beispielsweise in J. Am. Chem. Soc., 85, 454 (1963) beschrieben. Im Rahmen der Erfindung können H₂O₂, K₂Cr₂O₇, Alkali- und Ammoniumperoxodisulfate, wie z.B. Natrium- oder Kaliumperoxodisulfat, Alkaliper-borate, Kaliumpermanganat, Kupfersalze, wie Kupfertetrafluoroborat oder Cer(IV)-Salze bzw. CeO₂ als Oxidationsmittel eingesetzt werden. Bevorzugt sind preiswerte und leicht handhabbare Oxidationsmittel wie Eisen-III-Salze anorganischer Säuren, wie beispielsweise FeCl₃, Fe(ClO₄)₃, und die Eisen-III-Salze organischer Säuren und organische Reste aufweisender anorganischer Säuren.
Als Eisen-III-Salze organische Reste aufweisender anorganischer Säuren seien beispielsweise die Eisen-III-Salze der Schwefelsäurehalbester von C₁-C₂₀-Alkanolen, z.B. das Fe-III-Salz des Laurylsulfates genannt. Als Eisen-III-Salze organischer Säuren seien beispielsweise genannt: die Fe-III-Salze von C₁-C₂₀-Alkansulfonsäuren, wie der Methan- und der Dodecansulfonsäure, aliphatischen C₁-C₂₀-Carbonsäuren wie der 2-Ethylhexylcarbonsäure, aliphatischen Perfluorcarbonsäuren, wie der Trifluoressigsäure und der Perfluoroctansäure, aliphatischen Dicarbonsäuren, wie der Oxalsäure und vor allem von aromatischen, gegebenenfalls durch C₁-C₂₀-Alkylgruppen substituierten Sulfonsäuren wie der Benzolsulfonsäure, p-Toluolsulfonsäure und der Dodecylbenzolsulfonsäure und Cycloalkansulfonsäuren wie Camphersulfonsäure.
Im Rahmen der Erfindung steht C₁-C₂₀-Alkanol für einwertige Alkohole mit einem Alkylrest von 1 - 20 Kohlenstoffatomen. C₁-C₂₀-Alkansulfonsäure für einwertige Sulfonsäure mit einem Alkylrest von 1 - 20 Kohlenstoffatomen und eine C₁-C₂₀-Carbonsäure für einwertige Carbonsäuren mit einem Alkylrest von 1 - 20 Kohlenstoffatomen.

Überraschend wurde nun gefunden, dass für die Polymerisation des gegebenenfalls substituierten Thiophens der allgemeinen Formel (V) nur eine geringe Löslichkeit des eingesetzten Oxidationsmittels im Reaktionsmedium, d.h. dem unpolaren Lösungsmittel erforderlich ist. So ist beispielsweise Fe-III-tosylat im Toluol im Wesentlichen unlöslich. Dennoch wird EDT von Fe-III-tosylat in Toluol zu PEDT polymerisiert.

Somit ist ein weiterer Gegenstand der vorliegenden Erfindung ein Verfahren zur Herstellung eines Komplexes, wie in Anspruch 8 definiert.

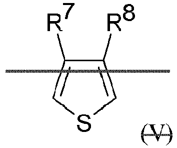

Bevorzugt als Oxidationsmittel sind Eisen(III) Salze aliphatischer und aromatischer Sulfonsäuren, besonders bevorzugt Eisen (III) p-toluolsulfonat. Besonders bevorzugt ist ein molares Verhältnis von 1 - 3 mol Eisen (III)-p-toluolsulfonat je mol Thiophen. Als Lösungsmittel können die oben aufgeführten mit Wasser nicht mischbaren Lösungsmittel verwendet werden.

Im Rahmen der Erfindung können auch Gemische dieser vorgenannten Fc-III-Salzc organischer Säuren eingesetzt werden. Die vorgenannten Fe-III-Salze können gegebenenfalls als Katalysatoren in Kombination mit anderen Oxidationsmitteln eingesetzt werden. Für die oxidative Polymerisation der gegebenenfalls substituierten Thiophene der Formel (V) werden theoretisch je Mol Thiophen 2,25 Äquivalente Oxidationsmittel benötigt (siehe z.B. J. Polym. Sc. Part A Polymer Chemistry Vol. 26, S. 1287 (1988)). Es können aber auch niedrigere oder höhere Äquivalente an Oxidationsmittel eingesetzt werden.

Offenbart ist auch ein Copolymer, welches wenigstens wiederkehrende Einheiten der allgemeinen Formeln (II a) und (III) enthält, 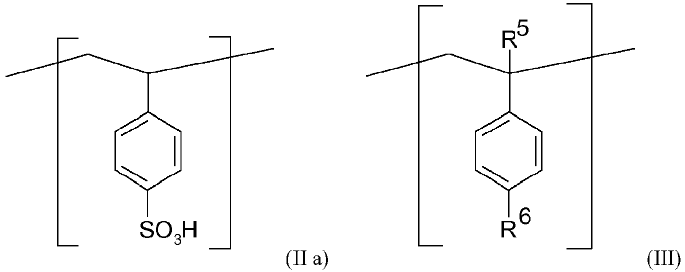 wobei
- R⁵: für H oder einen gegebenenfalls substituierten C₁-C₁₈-Alkylrest, bevorzugt für H, steht,
- R⁶: für H oder einen gegebenenfalls substituierten C₁-C₃₀-Alkylrest, bevorzugt für einen gegebenenfalls substituierten C₁-C₂₀-Alkylrest, besonders bevorzugt für einen gegebenenfalls substituierten C₁-C₁₂-Alkylrest, steht, und
der Massenanteil der Wiederholungseinheit (II a) zwischen 2% und 80%, bevorzugt zwischen 2% und 50%, liegt und
der Massenanteil der Wiederholungseinheit (III) zwischen 5% und 98%, bevorzugt 50 und 98%, liegt.

Die Definition für den hier aufgeführten C₁-C₁₈-Alkylrest und den aufgeführten C₁-C₃₀ Alkylrest entspricht der oben genannten Definition für diese Alkylreste.

Die wiederkehrenden Einheiten der allgemeinen Formeln (IIa) und (III) können innerhalb des Copolymers jeweils gleich oder verschieden sein. Bevorzugt sind Copolymere mit jeweils gleichen wiederkehrenden Einheiten der allgemeinen Formeln (IIa) und (III).

Das Copolymer weist ein Molekulargewicht auf, welches zwischen 2 000 bis 5 000 000 g/mol, bevorzugt zwischen 10 000 bis 1 000 000 g/mol, besonders bevorzugt zwischen 40 000 g/mol und 600 000 g/mol liegt.

Der Massenanteil der wiederkehrenden Einheiten gemäß der allgemeinen Formel (IIa) und (III) wurde mittels Elementaranalyse und ¹H-NMR bestimmt. In der Elementaranalyse werden berechnete und gefundene prozentuale Anteile verglichen. Im ¹H-NMR -Spektrum werden charakteristische Signale für die jeweiligen Wiederholungseinheiten ins Verhältnis gesetzt.

Das Copolymer ist in einem Lösungsmittel löslich oder dispergierbar, welches nicht mit Wasser mischbar ist. Als Lösungsmittel sind die oben aufgeführten Lösungsmittel geeignet, wobei aromatische oder aliphatische Kohlenwasserstoffe als Lösungsmittel bevorzugt sind.

Ein weiterer Gegenstand der vorliegenden Erfindung ist die Verwendung der erfindungsgemäßen Komplexe zur Herstellung leitfähiger Filme oder Lacksystemen oder als Lochinjektionsschicht in organischen Leuchtdioden.

Die folgenden Beispiele dienen lediglich der beispielhaften Erläuterung der Erfindung und sind nicht als Beschränkung aufzufassen.

### BEISPIELE:

### Beispiel 1: Synthese von 4-Dodecyl-Acetophenon

Aluminiumchlorid (227,114 g = 1,7 mol) wurde unter Argon in Methylenchlorid (800 ml) suspendiert und auf 0°C gekühlt. Dazu wurde in 100 ml Methylenchlorid gelöstes Essigsäureanhydrid (89,872 g = 0,88 mol) innerhalb von 30 Minuten (min.) langsam hinzugetropft. Die Mischung wurde etwa 15 min. gerührt und anschließend das (bei 0°C) in CH₂Cl₂ gelöste Dodecylbenzol (99,267 g = 0,4 mol) innerhalb von 30 min. tropfenweise unter Kühlung hinzugegeben. Die Reaktion wurde über Nacht ohne Kühlung weiter gerührt. Die erhaltene orangegelbe Reaktionslösung wurde langsam auf 1,5 L gestoßenes Eis gegossen, von der wässrigen Phase separiert und diese verworfen. Die organische Phase wurde je zweimal mit je 500 mL ∼10% Salzsäure, gesättigter Natriumcarbonat- und gesättigter Kochsalzlösung ausgeschüttelt. Die organische Phase wurde mit wasserfreiem Magnesiumsulfat getrocknet und das Lösungsmittel am Rotationsverdampfer abgezogen. Der erhaltene braune Feststoff wurde aus Methanol umkristallisiert. Die Kristallisation wurde bei 4 °C über Nacht erreicht.
Ausbeute: 106,669 g = 0,37 mol = 92,4 % der Theorie (d.Th.):
   Analysen: *250 MHz, CDCl₃; δ* = *0.90 (dd, 3H, J* = 5.7, 6.9 Hz*), 1.28 (m, 18H), 1.56-1.60 (m, 2H), 2.61 (s, 3H), 2.65 (t, 2H, J* = 7.3 Hz*), 7.27 (d, 2H, J* = 8.2 Hz*), 7.89 (d, 2H, J* = 8.2 Hz*).*

### Beispiel 2: Synthese von p-Dodecylphenyl-methylcarbinol

4-Dodecylacetophenon (106,669 g = 0,37 mol) wurde in Methanol (1,1 L) vorgelegt und unter Argon auf 0°C gekühlt. Dazu wurden in Abständen von 5 min. insgesamt 10 Portionen NaBH₄ (20,39 g = 0,54 mol) gegeben. Nach Abklingen der heftigen Gasentwicklung wurde das Eisbad entfernt, und die Reaktionslösung über Nacht bei Raumtemperatur weitergerührt. Die Lösung wurde bis zur Trockene eingeengt, und der weiße kristalline Rückstand in 1 L Hexan aufgenommen. Die erhaltene Suspension wurde zweimal mit je 500 mL ∼10% Salzsäure ausgeschüttelt, wobei sich der verbleibende Feststoff vollständig löste. Die organische Phase wurde zweimal mit je 500 mL gesättigter Kochsalzlösung ausgeschüttelt, über Magnesiumsulfat getrocknet, abfiltriert, anschließend am Rotationsverdampfer aufkonzentriert und bei -20°C auskristallisiert. Die Kristalle wurden abfiltriert und getrocknet.
Ausbeute: 100,032 g = 0,35 mol = 93,4 % d. Th.
Analysen: *250 MHz, CDCl₃; δ* = *0.90 (dd, 3H, J*=*5.4, 6.9 Hz), 1.20-1.35 (m, 18 H), 1.51 (d, 3H, J*= *6.3 Hz), 1.54-1.65 (m, 2H), 1.81 (d, 1H, J*=*1.9 Hz), 2.60 (t, 2H, J*=*7.9 Hz), 4.86 (m, 1H), 7.20 (d, 2H, J*=*7.9 Hz), 7.31 (d, 2H, J*=*7.9 Hz).*

### Beispiel 3: Synthese von p-Dodecylstyrol

In einem 2 L Rundkolben, der mit einem Wasserabscheider und einem Rückflusskühler versehen war, wurden 1,2 Liter Toluol vorgelegt und mit *p*-Dodecylphenyl-methylcarbinol (50,082 g = 0,173mol) und *p*-Toluolsulfonsäure-Monohydrat (0,679 g = 3,6 mmol) bestückt. Unter ständigem Rühren wurde die Mischung zum Refluxieren erhitzt und solange am Sieden gehalten, bis sich kein weiteres Wasser mehr abgeschieden hat. Nach Abkühlung der Reaktionsmischung auf Raumtemperatur wurde die organische Phase zweimal mit je 500 mL Wasser sowie einmal mit 250 mL gesättigter Kochsalzlösung ausgeschüttelt. Nach Trocknung über Magnesiumsulfat wurde das Lösungsmittel am Rotationsverdampfer abgezogen. Es wurde ein gelbes Öl erhalten. Anschließend wurden beide Ansätze vereinigt. Das Rohprodukt wurde an 400 g Kieselgel 60 mit Hexan als Eluent säulenchromatographisch gereinigt, wobei eine Fraktionsgröße von 100 mL gewählt wurde.
R_{f}(Carbinol) = 0 (Hexan)
R_{f}(Nebenprodukt) = 0.70 (Hexan)
R_{f}(n-Dodecylstyrol) = 0.50 (Hexan)
Ausbeute: 97,934 g = 0,36 mol
Analysen: *250 MHz, CDCl₃; δ* = *0.90 (t, 3H, J*=*6.6 Hz), 1.20-1.4 (m, 18 H), 1.60 (m, 2H), 2. 60 (t, 2 H, J*= *7.55 Hz), 5.22 (d, 1H, J*=*7.85 Hz), 5.73 (d, 1H, J*=*17.6 Hz), 6.71 (q, 1H), 7.15 (d, 2H, J*=*8.0 Hz), 7.35 (d, 2H, J*=*7.9 Hz)*

### Beispiel 4: Synthese des Silbersalzes der p-Styrolsulfonsäure

In einem 500 mL Rundkolben wurden 400 mL Wasser vorgelegt und unter Rühren bei Raumtemperatur (RT) 45,046 g Natrium p-Styrolsulfonat (45,046 g = 0,200 mol) darin gelöst. Der Kolben wurde, zur Gewährleistung von Lichtausschluss, mit Alufolie umwickelt. Die Lösung wurde auf 0°C gekühlt und portionsweise mit 34.225 g Silbernitrat (34,225 g = 0,200 mol) versetzt, wobei augenblicklich eine rosa Fällung entsteht. Alle folgenden Operationen wurden unter bestmöglichem Lichtausschluss ausgeführt. Der Ansatz wurde für weitere 30 min. bei 0°C gerührt und vom Feststoff über eine Glasfritte D2 abfiltriert. Der erhaltene Filterkuchen wurde in drei Portionen mit 150 mL Eiswasser gewaschen und mehrfach zur Trocknung mit kleinen Mengen Diethylether aufgeschlämmt. Der cremefarbige Feststoff wurde in 500 mL Acetonitril aufgenommen und von Unlöslichem über eine Glasfritte D4 abgetrennt. Die Lösung wurde zur Trockene eingeengt und der resultierende Feststoff über Nacht im Tiefkühlschrank gelagert.

Ausbeute: 47,890 g = 0,165 mol = 82,5 % d.Th.

### Beispiel 5: Synthese von p-Styrolsulfonsäureethylester

In einem mit Alufolie umwickelten 250 mL Rundkolben wurden 47,890 g Styrol-4-sulfonsäure Silbersalz (47,890 g = 0,165 mol) in 390 mL Acetonitril vorgelegt und unter Rühren mit einem Rührwal mit 35.77 g Ethylbromid (35,77 g = 0,33 mol) versetzt. Auf den Kolben wurde ein ebenfalls mit Alufolie ummantelter Rückflusskühler aufgesetzt und mit einem Argon-gefüllten Ballon versehen. Der Reaktionsansatz wurde für 5 Stunden (h) bei 70 °C gerührt, nach Abkühlen auf Raumtemperatur wurde das entstandene Silberbromid über eine Fritte D4 abgetrennt und das Filtrat am Rotationsverdampfer eingeengt. Das verbleibende Öl wurde mit 400 mL Dichlormethan (DCM) aufgenommen und durch ein Fritte D4 mit 5 cm hoher Kieselgelauflage filtriert. Das Filtermaterial wurde mehrfach mit jeweils 50 mL DCM extrahiert und das Lösungsmittel abgezogen. Es wurde ein gelbes hochviskoses Öl erhalten.
Ausbeute: 29,457 g = 0,139 mol = 84,2 % d.Th.
Analytik (NMR): *250 MHz, CDCl₃; δ* = *1.30 (t, 3H, J*= *7.3 Hz), 4.12 (q, 2H, J*= *7.3 Hz), 5.46 (d, 1H, J*=*11.1 Hz), 5.96 (d, 1H, J*=*17.7 Hz), 6.77 (dd, 1H, J*=*11.1, 17,4 Hz), 7. 65 (d, 2H, J*=*8.2 Hz), 7.86 (d, 2H, J=8.2 Hz).*

### Beispiel 6: Synthese von Poly(p-styrolsulfonsäureethylester-co-p-dodecylstyrol)

Unter Argonatmosphäre wurde in einem 500 mL Kolben Dichlorethan (250 g) als Lösungsmittel vorgelegt. Nach Zugabe von 35,0 g *para*-Dodecylstyrol (35,0 g = 128,45 mmol; Herstellung in Beispiel 3 beschrieben) und 7,28 g *para*-Styrolsulfonsäureethylester (7,28 g = 34,30 mmol; Herstellung in Beispiel 5 beschrieben) wurde der Ansatz über ein Gaseinleitungsrohr mit Argon gesättigt. Hierzu wurde für 15 min. Argon durch den Ansatz geleitet. Währenddessen wurde der Ansatz auf 60°C erhitzt. Als Radikalstarter wurde Azobisisobutyronitril (AIBN) eingesetzt, das nach dem Sättigen mit Argon, in wenig Dichlorethan gelöst, durch ein Septum zugesetzt wurde. Die Polymerisationslösung wurde für weitere 5 min. mit Argon durchflutet und anschließend über Nacht bei 60°C auspolymerisiert. Nach Abkühlen der leicht viskosen Polymerlösung, wurde das Polymer unter Rühren in Methanol ausgefällt. Das nach der Fällung erhaltene Polymer wurde anschließend erneut in Tetrahydrofuran (THF) gelöst und wieder in Methanol ausgefällt. Das isolierte weiße Polymer wurde im Hochvakuum getrocknet.
Ausbeute: 18 g = 42,6 % d.Th.
Analytik (GPC): Molekulargewicht (vs. PS in THF): 120 000 g/mol, Dispersität D (M_{w}/Mₙ) : 1,5
Analytik (NMR): *250 MHz, CDCl3; δ* = *0.88 (3H), 1.20-1.30 (-CH2-, -CH), 1.40-1.45 (3H, -CH3 Ester) 1.45-1,55 (2H), 2.50-2.60 (2H),4.0-4.1 (2H, -CH2-Ester), 6.0-7.0(4H),7.3-7.6 (4H, -CH-Erster)*
Aus NMR-Spektroskopischen Analysen kann der Sulfonierungsgrad bestimmt werden; hierzu werden die Peaks bei 0.88 ppm (CH₃ Terminus der Dodecylgruppe) und 4.0-4.1 ppm (CH₂ des

Ethylesters) in Relation gesetzt. Es ergibt sich ein integralbereinigtes Verhältnis von Dodecylstyrol zu Styrolsulfonsäureethylester von 1:5,6, wobei dieses Verhältnis einem Sulfonierungssgrad des Polymers von 21,09 % entspricht

### Analytik - Elementaranalyse (EA):

| Element | Wert 1 [%] | Wert 2 [%] | Ø [%] | m/M [mol] |
|---|---|---|---|---|
| C | 75,67 | 75,32 | 75,50 | 6,29 |
| H | 9,38 | 9,20 | 9,29 | 9,29 |
| S | 2,48 | 2,12 | 2,30 | 0,072 |

Somit ergibt sich ein Sulfonierungsgrad von 18,77 %.

Hieraus folgt für den Sulfonierungsgrad:

| Sulfonierungsgrad [%] | | |
|---|---|---|
| theoretisch | EA | NMR |
| 21,07 | 18,77 | 21,09 |

### Beispiel 7 (erfindungsgemäß): Synthese von Poly(p-styrolsulfonsäure-co-p-dodecylstyrol)

15,0 g Poly(*p*-styrolsulfonsäureethylester-co-*p*-dodecylstyrol) (Herstellung wie in Beispiel 6 beschrieben) wurde in 50 mL Dichlorethan und 100 mL Toluol gelöst und auf 100°C erwärmt. Während des Aufheizens wurde die Lösung mit Argon entgast. 60 g Trimethlysilylbromid (TMSBr) (60 g = 16,33 mmol) wurden durch ein Septum über einen Zeitraum von 5 min. zugesetzt. Die gelbe Lösung wurde für 60 h bei 100 °C unter Rückfluss gerührt, anschließend eingeengt, und das Polymer in Methanol/Wasser ausgefällt. Das nach der Fällung erhaltene Polymer wurde anschließend erneut in Tetrahydrofuran (THF) gelöst und erneut in Methanol ausgefällt. Das isolierte gelbliche Polymer wurde im Hochvakuum getrocknet.
Ausbeute: 10 g
Analytik (EA):

| Element | Wert 1 [%] | Wert 2 [%] | Ø [%] | m/M [mol] |
|---|---|---|---|---|
| C | 76,38 | 76,72 | 76,55 | 6,38 |
| H | 10,03 | 10,07 | 10,05 | 10,05 |
| S | 2,62 | 2,63 | 2,63 | 0,082 |

Somit ergibt sich ein Sulfonierungsgrad von 20,8 % (gerechnet bei vollständiger Hydrolyse)
Analytik (NMR): *250 MHz, CDCl₃; δ* = *0.88 (3H), 1.20-1.40 (-CH2-, -CH-), 1.45-1,55 (2H), 2.50-2.60 (2H), 6.0-7.0 (4H), 7.3-7.6 (-CH- Aromat d. Ester)*

Aus NMR-Spektroskopischen Analysen kann der Hydrolysegrad des Esters bestimmt werden; hierzu werden die Peaks bei 0.88 ppm (CH₃ Terminus der Dodecylgruppe) und dem kaum noch zu erkennenden Peak bei 4.11 ppm (CH₂ des Ethylesters) in Relation gesetzt (1:53,3). Daraus ergibt sich ein Hydrolysegrad des Esters von ca. 86,7%.

Analytik (GPC):
Die Probe wurde in Tetrahydrofuran gelöst. Als Kalibrierstandard diente Polystyrol. Als Detektoren dienten ein UV Detektor und ein Berechungsindex-Detektor(RI).

| Detektor | Mₙ [g/mol] | M_{w} [g/mol] | D (M_{w}/Mₙ) |
|---|---|---|---|
| UV 254 nm | 72000 | 120000 | 1,7 |
| RI | 74000 | 118000 | 1,6 |

### Beispiel 8 (erfindungsgemäß): Synthese eines Poly(3,4-ethylendioxythiophen)/Poly(p-styrolsulfonsäure-co-p-dodecylstyrol)- Komplexes

In einem 50 ml Rundkolben wurden 12,5 g Toluol und 1 g Poly(*p*-styrolsulfonsäure-co-*p-*dodecylstyrol) aus Beispiel 7 vorgelegt und 10 min. gerührt. Anschließend wurden 0,3 g (2,1 mmol) Ethylendioxythiophen (Clevios M V2, H.C. Starck GmbH) zugesetzt. Anschließend wurden 1,33 g Eisen(III)tosylat (2,3 mmol) zugesetzt und 24 h bei Raumtemperatur gerührt. Danach wurde der Rührer ausgeschaltet, und die erhaltene Dispersion nach 10 min. abdekantiert. Nach weiteren 48 h wurde die Mischung über einen Filter mit einer Porengröße von 0,45 µm filtriert.

Analytik: Feststoffgehalt
Zur Bestimmung des Feststoffgehalts wurden 2 g der Probe für 16 h bei 100°C getrocknet.
Aus der Einwaage und dem Trockengehalt wurde ein Feststoffgehalt von 8,11% ermittelt.

### Beispiel 9 (erfindungsgemäß): Bestimmung des spezifischen Widerstands und Einsatz des Komplexes im OLED

Die erfindungsgemäße Formulierung des Poly(3,4-ethylendioxythiophen)/Poly(p-styrolsulfonsäure-co-p-dodecylstyrol)-Komplexes aus Beispiel 8 wurde zum Aufbau einer organischen Leuchtdiode (OLED) genutzt. Bei der Herstellung der OLED wurde folgendermaßen vorgegangen:
Vorbereitung des ITO-beschichteten Substrats (ITO = Indiumzinnoxid)
ITO-beschichtetes Glas (Merck Balzers AG, FL, Part. No. 253 674 XO) wird in 50 mm x 50 mmgroße Stücke (Substrate) geschnitten. Die Substrate wurden anschließend in 3 %iger wässriger Mukasollösung im Ultraschallbad 15 min. lang gereinigt. Danach wurden die Substrate mit destilliertem Wasser gespült und in einer Zentrifuge trocken geschleudert. Dieser Spül- und Trockenvorgang wurde 10-mal wiederholt. Unmittelbar vor der Beschichtung wurden die ITO-beschichteten Seiten in einem UV/Ozon-Reaktor (PR-100, UVP Inc., Cambridge, GB) für 10 min gereinigt.

### Aufbringen der lochinjizierenden Schicht

Etwa 5 ml der erfindungsgemäßen Dispersion aus Beispiel 8 wurden filtriert (Millipore HV, 0,45 µm). Das gereinigte ITO-beschichtete Substrat wurde auf eine Lackschleuder gelegt und die filtrierte Lösung wurde auf der ITO-bcschichtctcn Seite des Substrats verteilt. Anschließend wurde die überstehende Lösung durch Rotation des Tellers bei 1500 U/min über den Zeitraum von 30 Sekunden abgeschleudert. Danach wurde das so beschichtete Substrat 15 min. lang bei 130 °C auf einer Heizplatte getrocknet. Die Schichtdicke betrug 500 nm (Tencor, Alphastep 500).

Alle weiteren Prozessschritte wurden in reiner N₂-Atmosphäre durchgeführt (Inertgas-Gloveboxsystem, M.Braun, Garching), in die das beschichtete Substrat transferiert wird. Zunächst wurde das mit der Dispersion aus Beispiel 8 beschichtete Substrat 5 min. lang bei 180 °C auf einer Heizplatte nachgetrocknet.

An separaten Schichten wurde die Leitfähigkeit der Dispersion aus Beispiel 8 bestimmt, indem über eine Schattenmaske Ag-Elektroden mit 2,5 cm Länge in einem Abstand von 0,5mm aufgedampft wurden (analog Prozessschritt 4). Der mit einem Elektrometer bestimmte Oberflächenwiderstand wurde mit der Schichtdicke multipliziert, um den elektrischen spezifischen Widerstand zu erhalten. Der spezifische Widerstand dieser Schichten betrug ca. 100 000 000 Ohmcm.

### Aufbringen der Emitterschicht

5 ml einer 1 Gew.-% Xylol-Lösung eines weissen polymeren Emitters wurden filtriert (Millipore HV, 0,45 µm) und auf der getrockneten lochinjizierenden Schicht verteilt. Anschließend wurde die überstehende Lösung des Emitters durch Rotation des Tellers bei 2500 U/min mit geschlossenem Deckel 30 Sekunden lang abgeschleudert. Danach wurde die Schicht auf einer Heizplatte bei 180°C für 10 min. getrocknet. Die Gesamtschichtdicke betrug 585 nm.

### Aufbringen der Metallkathode

Auf die Emitterschicht wurde eine Metallelektrode als Kathode gedampft. Dazu wurde das Substrat mit der Emitterschicht nach unten auf eine Schattenmaske gelegt, die Löcher mit 2,5 mm Durchmesser enthält. Aus zwei Aufdampfschiffchen wurden bei einem Druck von p = 10-3 Pa nacheinander eine 5 nm dicke Ba-Schicht und anschließend eine 200 nm dicke Ag-Schicht aufgedampft. Die Aufdampfraten betrugen 10 Å/s für Ba und 20 Å/s für Ag. Die isolierten Metallelektroden wiesen eine Fläche von 4,9 mm² auf.

### Charakterisierung der OLED

Die beiden Elektroden der organischen LED wurden über elektrische Zuführungen mit einer Spannungsquelle verbunden (kontaktiert). Der positive Pol wurde mit der ITO-Elektrode, der negative Pol wurde über einen dünnen flexiblen Au-Draht mit der Metall-Elektrode verbunden. Die Abhängigkeit des OLED-Stroms und der Elektrolumineszenzintensität (der Nachweis erfolgt mit einer Photodiode (EG&G C30809E)) von der Spannung wurden aufgezeichnet. Anschließend wurde die Lebensdauer bestimmt, indem ein konstanter Strom von I = 60 µA durch die Anordnung geflossen ist, und die Spannung und Lichtintensität zeitabhängig verfolgt wurde.

### Ergebnisse

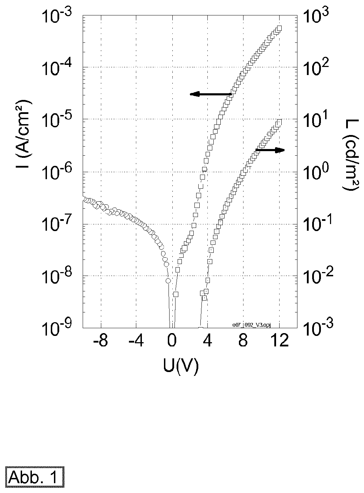

Die so hergestellte OLED zeigte das typische Diodenverhalten organischer Leuchtdioden (vgl. Abb.1). Bei 12 Volt angelegter Spannung U betrug der Durchlassstrom I 0.57A/cm² und die Leuchtdichte L 9.2cd/m². Die Lebensdauer, definiert durch den Leuchtdichteabfall auf die Hälfte der Anfangsleuchtdichte, beträgt 60 Stunden bei einem konstanten Diodenstrom von 60µA.

Damit ist die prinzipielle Eignung von wasserfreien PEDOT enthaltenden Lösungen auf Basis der erfindungsgemäßen Dispersion aus Beispiel 8 gezeigt worden.

## Patentansprüche

1. Komplex umfassend ein gegebenenfalls substituiertes Polythiophen und ein Polyanion, **dadurch gekennzeichnet, dass** das Polyanion ein Copolymer mit wiederkehrenden Einheiten der allgemeinen Formeln (I) und (III), oder wiederkehrenden Einheiten der allgemeinen Formeln (II) und (III), oder wiederkehrenden Einheiten der allgemeinen Formeln (I), (II) und (III) enthält 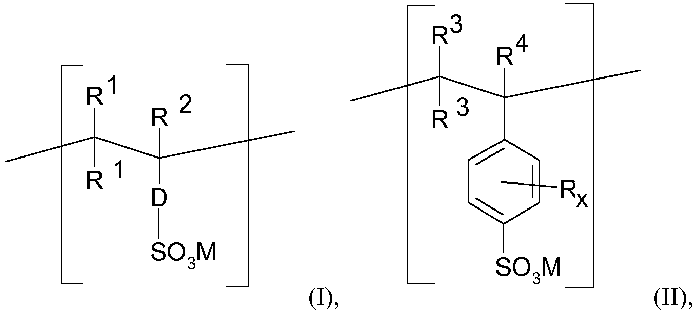 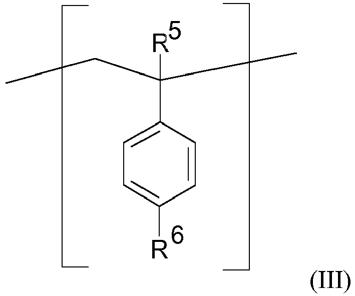 wobei
R¹, R²,R³,R⁴,R⁵ unabhängig voneinander jeweils für H, einen gegebenenfalls substituierten C₁-C₁₈-Alkylrest, einen gegebenenfalls substituierten C₁-C₁₈-Alkoxyrest, einen gegebenenfalls substituierten C₅-C₁₂-Cycloalkylrest, einen gegebenenfalls substituierten C₆-C₁₄-Arylrest, einen gegebenenfalls substituierten C₇-C₁₈-Aralkylrest, einen gegebenenfalls substituierten C₁-C₄-Hydroxy-alkylrest oder einen Hydroxylrest steht,
R⁶ einen gegebenenfalls substituierten C₁-C₃₀-Alkylrest darstellt,
D für eine direkte kovalente Bindung oder einen gegebenenfalls substituierten C₁-C₅-Alkylenrest steht
R für einen linearen oder verzweigten, gegebenenfalls substituierten C₁-C₁₈ Alkylrest, einen gegebenenfalls substituierten C₅-C₁₂-Cycloalkylrest, einen gegebenenfalls substituierten C₆-C₁₄-Arylrest, einen gegebenenfalls substituierten C₇-C₁₈-Aralkylrest, einen gegebenenfalls substituierten C₁-C₄-Hydroxyalkylrest oder einen Hydroxylrest steht,
x für eine ganze Zahl von 0 bis 4,
M für H oder Li⁺, Na⁺, K⁺, Rb⁺, Cs⁺, NH₄⁺, Na⁺, K⁺ oder ein anderes Kation, steht.

2. Komplex gemäß Anspruch 1, **dadurch gekennzeichnet, dass** das Polyanion ein Copolymer mit wiederkehrenden Einheiten der Formeln (II) und (III) ist.

3. Komplex gemäß Anspruch 2 , **dadurch gekennzeichnet, dass** das Polyanion ein Copolymer mit wiederkehrenden Einheiten der Formeln (IIa) und (III) enthält 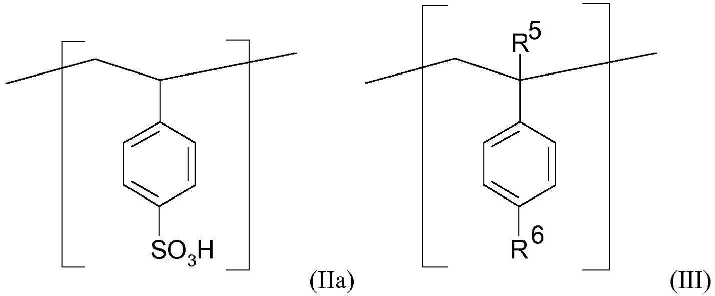 wobei
R⁵ für H oder einen gegebenenfalls substituierten C₁-C₁₈-Alkylrest steht und
R⁶ H oder einen gegebenenfalls substituierten C₁-C₃₀-Alkylrest darstellt.

4. Komplex gemäß wenigstens einem der Ansprüche 1 bis 3, **dadurch gekennzeichnet, dass** das Molekulargewicht des Polyanions zwischen 2 000 bis 5 000 000 g/mol liegt.

5. Komplex gemäß wenigstens einem der Ansprüche 1 bis 4, **dadurch gekennzeichnet, dass** das gegebenenfalls substituierte Polythiophen wiederkehrende Einheiten der allgemeinen Formel (IV) enthält 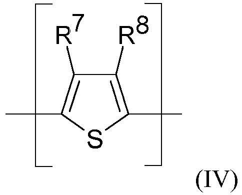 wobei
R⁷ und R⁸ unabhängig voneinander jeweils für H, einen gegebenenfalls substituierten C₁-C₁₈-Alkylrest oder einen gegebenenfalls substituierten C₁-C₁₈-Alkoxyrest, oder
R⁷ und R⁸ zusammen für einen gegebenenfalls substituierten C₁-C₈-Alkylenrest, worin ein oder mehrere C-Atom(e) durch ein oder mehrere gleiche oder unterschiedliche Heteroatome ausgewählt aus O oder S ersetzt sein können, bevorzugt einen C₁-C₈-Dioxyalkylenrest, einen gegebenenfalls substituierten C₁-C₈-Oxythiaalkylenrest oder einen gegebenenfalls substituierten C₁-C₈-Dithiaalkylenrest, oder für einen gegebenenfalls substituierten C₁-C₈-Alkylidenrest, worin gegebenenfalls wenigstens ein C-Atom durch ein Heteroatom ausgewählt aus O oder S ersetzt sein kann, stehen.

6. Komplex gemäß wenigstens einem der Ansprüche 1 bis 5, **dadurch gekennzeichnet, dass** das gegebenenfalls substituierte Polythiophen wiederkehrende Einheiten der allgemeinen Formel (IV-aaa) und/oder der allgemeinen Formel (IV-aba) enthält

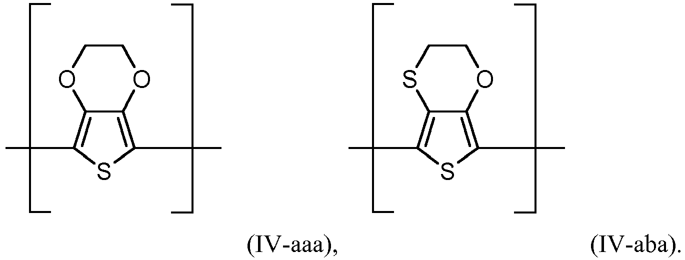

7. Komplex nach wenigstens einem der Ansprüche 1 bis 6, **dadurch gekennzeichnet, dass** der Komplex in mit Wasser nicht mischbaren Lösungsmitteln ausgewählt aus der Gruppe bestehend aus aromatischen oder aliphatischen Kohlenwasserstoffen, aliphatischen Carbonsäureestern, Chlorkohlenwasserstoffen, aliphatischen oder araliphatischen Ethern löslich oder dispergierbar ist.

8. Verfahren zur Herstellung eines Komplexes gemäß wenigstens einem der Ansprüche 1 bis 7 in Gegenwart der Polyanionen, **dadurch gekennzeichnet, dass** die oxidative Polymerisation von gegebenenfalls substituierten Thiophenen der allgemeinen Formel (V) 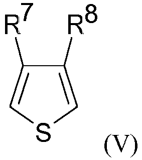 unter Verwendung von Eisen(III)-Salzen von anorganischen Säuren, von organischen Säuren oder von organische Reste aufweisenden anorganischen Säuren als Oxidationsmittel, wobei das Thiophen und das Oxidationsmittel im einem molaren Verhältnis von 0,5 - 10 eingesetzt werden, in unpolaren Lösungsmitteln durchgeführt wird und wobei R⁷ und R⁸ die unter Anspruch 5 genannte Bedeutung haben.

9. Verwendung eines Komplexes gemäß wenigstens einem der Ansprüche 1 bis 7 zur Herstellung von leitfähigen Filmen oder Lacksystemen, oder als Lochinjektionsschicht in organischen Leuchtdioden.

## Claims

1. Complex comprising an optionally substituted polythiophene and a polyanion, **characterized in that** the polyanion contains a copolymer with repeat units of the general formulae (I) and (III), or repeat units of the general formulae (II) and (III), or repeat units of the general formulae (I), (II) and (III) 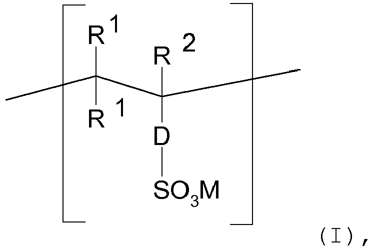 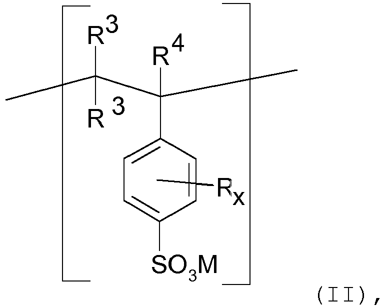 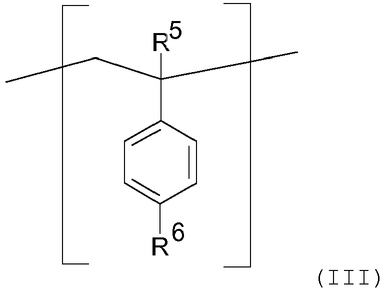 where
R¹, R², R³,R⁴,R⁵ are each independently H, an optionally substituted C₁-C₁₈-alkyl radical, an optionally substituted C₁-C₁₈-alkoxy radical, an optionally substituted C₅-C₁₂-cycloalkyl radical, an optionally substituted C₆-C₁₄-aryl radical, an optionally substituted C₇-C₁₈-aralkyl radical, an optionally substituted C₁-C₄-hydroxyalkyl radical or a hydroxyl radical,
R⁶ is an optionally substituted C₁-C₃₀-alkyl radical,
D is a direct covalent bond or an optionally substituted C₁-C₅-alkylene radical
R is a linear or branched, optionally substituted C₁-C₁₈ alkyl radical, an optionally substituted C₅-C₁₂-cycloalkyl radical, an optionally substituted C₆-C₁₄-aryl radical, an optionally substituted C₇-C₁₈-aralkyl radical, an optionally substituted C₁-C₄-hydroxyalkyl radical or a hydroxyl radical,
x is an integer from 0 to 4,
M is H or Li⁺, Na⁺, K⁺, Rb⁺, Cs⁺, NH₄⁺, Na⁺, K⁺ or another cation.

2. Complex according to Claim 1, **characterized in that** the polyanion is a copolymer with repeat units of the formulae (II) and (III).

3. Complex according to Claim 2, **characterized in that** the polyanion contains a copolymer with repeat units of the formulae (IIa) and (III) 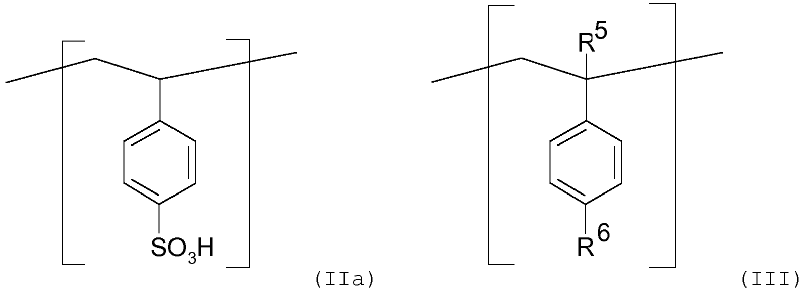 where
R⁵ is H or an optionally substituted C₁-C₁₈-alkyl radical and
R⁶ is H or an optionally substituted C₁-C₃₀-alkyl radical.

4. Complex according to at least one of Claims 1 to 3, **characterized in that** the molecular weight of the polyanion is between 2 000 to 5 000 000 g/mol.

5. Complex according to at least one of Claims 1 to 4, **characterized in that** the optionally substituted polythiophene contains repeat units of the general formula (IV) 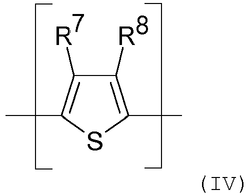 where
R⁷ and R⁸ are each independently H, an optionally substituted C₁-C₁₈-alkyl radical or an optionally substituted C₁-C₁₈-alkoxy radical, or
R⁷ and R⁸ together are an optionally substituted C₁-C₈-alkylene radical in which one or more carbon atom(s) may be replaced by one or more identical or different heteroatoms selected from O and S, preferably a C₁-C₈-dioxyalkylene radical, an optionally substituted C₁-C₈-oxythiaalkylene radical or an optionally substituted C₁-C₈-dithiaalkylene radical, or an optionally substituted C₁-C₈-alkylidene radical in which at least one carbon atom may optionally be replaced by a heteroatom selected from O and S.

6. Complex according to at least one of Claims 1 to 5, **characterized in that** the optionally substituted polythiophene contains repeat units of the general formula (IV-aaa) and/or of the general formula (IV-aba)

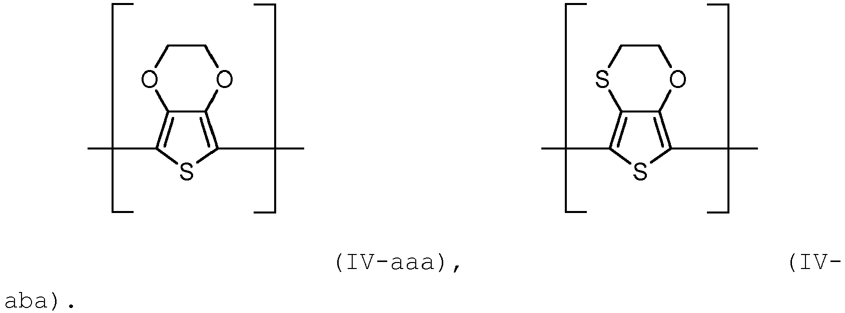

7. Complex according to at least one of Claims 1 to 6, **characterized in that** the complex is soluble or dispersible in water-immiscible solvents selected from the group consisting of aromatic and aliphatic hydrocarbons, aliphatic carboxylic esters, chlorohydrocarbons, aliphatic or araliphatic ethers.

8. Process for preparing a complex according to at least one of Claims 1 to 7 in the presence of the polyanions, **characterized in that** the oxidative polymerization of optionally substituted thiophenes of the general formula (V) 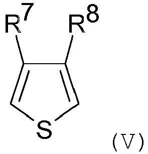 is performed using iron (III) salts of inorganic acids, of organic acids, or of inorganic acids having organic radicals as oxidizing agents, the thiophene and the oxidizing agent being used in a molar ratio of 0.5 - 10, in nonpolar solvents, and where R⁷ and R⁸ are each as defined in Claim 5.

9. Use of a complex according to at least one of Claims 1 to 7 for producing conductive films or coating systems, or as a hole injection layer in organic light-emitting diodes.

## Revendications

1. Complexe comprenant un polythiophène le cas échéant substitué et un polyanion, **caractérisé en ce que** le polyanion contient un copolymère présentant des unités récurrentes des formules générales (I) et (III) ou des unités récurrentes des formules générales (II) et (III) ou des unités récurrentes des formules générales (I), (II) et (III) 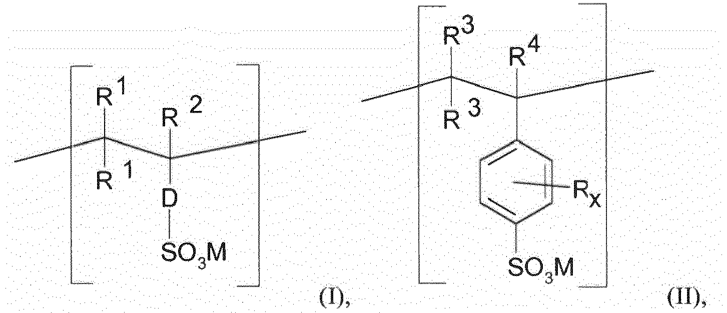 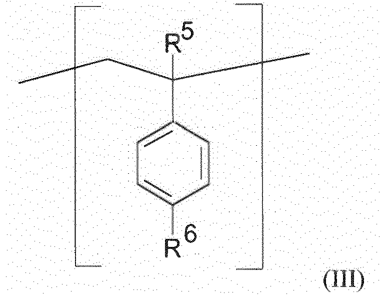 dans lesquelles
R¹,R²,R³,R⁴,R⁵ représentent, indépendamment les uns des autres, à chaque fois H, un radical C₁-C₁₈-alkyle le cas échéant substitué, un radical C₁-C₁₈-alcoxy le cas échéant substitué, un radical C₅-C₁₂-cycloalkyle le cas échéant substitué, un radical C₆-C₁₄-aryle le cas échéant substitué, un radical C₇-C₁₈-aralkyle le cas échéant substitué, un radical C₁-C₄-hydroxyalkyle le cas échéant substitué ou un radical hydroxyle,
R⁶ représente un radical C₁-C₃₀-alkyle le cas échéant substitué,
D représente une liaison covalente directe ou un radical C₁-C₅-alkylène le cas échéant substitué,
R représente un radical C₁-C₁₈-alkyle linéaire ou ramifié, le cas échéant substitué, un radical C₅-C₁₂-cycloalkyle le cas échéant substitué, un radical C₆-C₁₄-aryle le cas échéant substitué, un radical C₇-C₁₈-aralkyle le cas échéant substitué, un radical C₁-C₄-hydroxyalkyle le cas échéant substitué ou un radical hydroxyle,
x représente un nombre entier de 0 à 4,
M représente H ou Li⁺, Na⁺, K⁺, Rb⁺, Cs⁺, NH₄⁺, Na⁺, K⁺ ou un autre cation.

2. Complexe selon la revendication 1, **caractérisé en ce que** le polyanion est un copolymère présentant des unités récurrentes des formules (II) et (III).

3. Complexe selon la revendication 2, **caractérisé en ce que** le polyanion contient un copolymère présentant des unités récurrentes des formules (IIa) et (III) 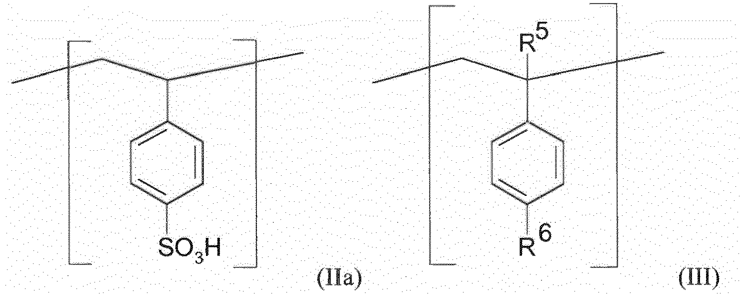 dans lesquelles
R⁵ représente H ou un radical C₁-C₁₈-alkyle le cas échéant substitué et
R⁶ représente H ou un radical C₁-C₃₀-alkyle le cas échéant substitué.

4. Complexe selon au moins l'une quelconque des revendications 1 à 3, **caractérisé en ce que** le poids moléculaire du polyanion est situé entre 2000 à 5.000.000 g/mole.

5. Complexe selon au moins l'une quelconque des revendications 1 à 4, **caractérisé en ce que** le polythiophène le cas échéant substitué contient des unités récurrentes de formule générale (IV) 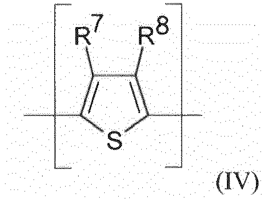 dans laquelle
R⁷ et R⁸ représentent, indépendamment l'un de l'autre, à chaque fois H, un radical C₁-C₁₈-alkyle le cas échéant substitué ou un radical C₁-C₁₈-alcoxy le cas échéant substitué ou
R⁷ et R⁸ représentent ensemble un radical C₁-C₈-alkylène le cas échéant substitué, un ou plusieurs atomes de C pouvant être remplacés par un ou plusieurs hétéroatomes identiques ou différents, choisis parmi O ou S, de préférence un radical C₁-C₈-dioxyalkylène, un radical C₁-C₈-oxythiaalkylène le cas échéant substitué ou un radical C₁-C₈-dithiaalkylène le cas échéant substitué ou un radical C₁-C₈-alkylidène le cas échéant substitué dans lequel le cas échéant au moins un atome de carbone peut être remplacé par un hétéroatome choisi parmi O ou S.

6. Complexe selon au moins l'une quelconque des revendications 1 à 5, **caractérisé en ce que** le polythiophène le cas échéant substitué contient des unités récurrentes de formule générale (IV-aaa) et/ou de formule générale (IV-aba)

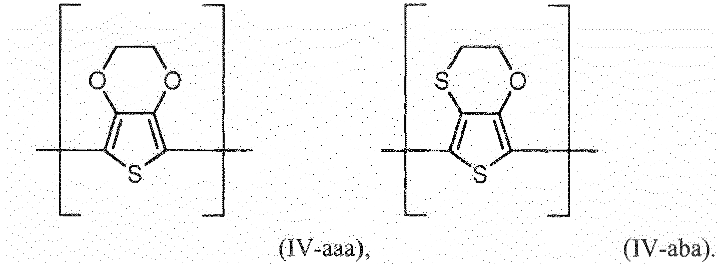

7. Complexe selon au moins l'une quelconque des revendications 1 à 6, **caractérisé en ce que** le complexe est soluble ou dispersible dans des solvants non miscibles à l'eau, choisis dans le groupe constitué par les hydrocarbures aromatiques ou aliphatiques, les esters d'acides carboxyliques aliphatiques, les hydrocarbures chlorés, les éthers aliphatiques ou araliphatiques.

8. Procédé pour la préparation d'un complexe selon au moins l'une quelconque des revendications 1 à 7 en présence des polyanions, **caractérisé en ce que** la polymérisation oxydante de thiophènes le cas échéant substitués de formule générale (V) 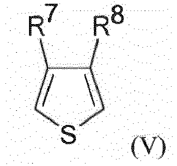 est réalisée avec utilisation de sels de fer (III) d'acides inorganiques, d'acides organiques ou d'acides inorganiques présentant des radicaux organiques comme oxydant, le thiophène et l'oxydant étant utilisés dans un rapport molaire de 0,5-10, dans des solvants non polaires et R⁷ et R⁸ présentant la signification mentionnée dans la revendication 5.

9. Utilisation d'un complexe selon au moins l'une quelconque des revendications 1 à 7 pour la préparation des films ou de systèmes de laques, conducteurs, ou comme couches d'injection de trous dans des diodes électroluminescentes organiques.
